# EUROPEAN PATENT SPECIFICATION

(11) **EP 4 056 534 B1**
(45) Date of publication and mention of the grant of the patent: **28.02.2024**
(21) Application number: 21173938.8
(22) Date of filing: 14.05.2021
(51) Int. Cl.: C01B 32/186, C01B 32/194, H01M 4/90

(54) **NEODYMIUM-GRAPHENE COMPOSITE MATERIAL AND PREPARATION METHOD AND APPLICATION THEREOF**
NEODYM-GRAPHEN-VERBUNDMATERIAL UND HERSTELLUNGSVERFAHREN UND ANWENDUNG DAVON
MATÉRIAU COMPOSITE NÉODYME-GRAPHÈNE ET SON PROCÉDÉ DE PRÉPARATION ET SON APPLICATION

(30) Priority: 10.03.2021 CN 202110261743
(43) Date of publication of application: 14.09.2022
(73) Proprietor: Jiangxi University of Science and Technology, Ganzhou City, Jiangxi 341000 (CN)
(72) Inventor: JIANG, Honghui, Ganzhou city, 341000 (CN); SAGAR, Rizwan Ur Rehman, Ganzhou city, 341000 (CN); CHEN, Lifang, Ganzhou city, 341000 (CN); LIANG, Tongxiang, Ganzhou city, 341000 (CN); DENG, Yiqun, Ganzhou city, 341000 (CN)
(74) Representative: Chung, Hoi Kan

(56) References cited:
- WO-A1-2017/155468
- CN-A- 107 245 597
- Devadas Balamurugan ET AL: "Electrochemically Reduced Graphene Oxide/ Neodymium Hexacyanoferrate Modified Electrodes for the Electrochemical Detection of Paracetomol", Int. J. Electrochem. Sci. International Journal, 1 January 2012 (2012-01-01), 1 April 2012 (2012-04-01), pages 3339-3349, XP55857610, Retrieved from the Internet: URL:http://www.electrochemsci.org/papers/v ol7/7043339.pdf [retrieved on 2021-11-03]
- TRINSOUTROT PIERRE ET AL: "Three dimensional graphene synthesis on nickel foam by chemical vapor deposition from ethylene", MATERIALS SCIENCE AND ENGINEERING: B, vol. 179, 12 October 2013 (2013-10-12), pages 12-16, XP028782653, ISSN: 0921-5107, DOI: 10.1016/J.MSEB.2013.09.018

## Description

### TECHNICAL FIELD

The present invention relates to the technical field of catalytic materials, in particular to a neodymium-graphene composite material and a preparation method and an application thereof.

### BACKGROUND

The preparation of hydrogen and oxygen by electrocatalytic cracking of water is a safe and sustainable way to obtain clean energy, which has important application value and research significance in the efficient use of renewable clean energy, alleviation of the energy crisis, and prevention of environmental pollution. At present, the best hydrogen and oxygen evolution catalysts are respectively Pt-based and Ir/Ru-based materials. Such noble metal catalytic materials are limited in reserves and of high cost, limiting their use in large-scale applications. Therefore, it is of great significance to search for cheap non-noble metal catalysts with abundant reserves and excellent performance.

The performance of the catalysts mainly depends on the intrinsic activity of active catalytic sites in the catalysts and the number of the catalytic sites. So far, the number of high-efficient hydrogen evolution catalysts used in alkaline media is far less than that of acidic catalysts. Moreover, the development of the hydrogen evolution catalysts with high activity and high stability in the alkaline media has important industrial application value and broad application prospects.

Among transition metal materials, nickel-based catalysts have been extensively studied due to their excellent corrosion resistance in the alkaline media. Due to the special three-dimensional electron distribution of the nickel-based catalysts, the nickel-based catalysts are considered as one of the most promising electrode materials for hydrogen evolution in the alkaline media. Most of the existing research take graphene as the main body, and a series of materials are prepared by combining the graphene with transition metals. For example, the prior art discloses a preparation method of a material with a three-dimensional well-developed pore structure, which comprises the steps of: preparing a three-dimensional graphene block through high-temperature carbonization and graphitization of a polymer product, then conducting nitrogen-doped reaction under ammonia gas to obtain a high-strength nitrogen-doped graphene material, and finally introducing a MoS2 material to prepare the material with the three-dimensional well-developed pore structure. The prior art also discloses a preparation method and an application of a catalyst with Ni₂P loaded graphene foam structure; the technological process of the preparation method follows the below steps: soaking the nickel foam in a graphene oxide solution, and enabling the graphene oxide to be loaded and grow on the surface of the nickel foam in an environment saturated with rare gas, taking out the sample after freeze-drying to obtain a monodisperse ultra-small NiO graphene-loaded foaming structure catalyst; and performing phosphating on the freeze-dried sample to obtain a monodisperse ultra-small Ni₂P graphene-loaded foaming structure catalyst.

For transition metal and carbon material composite catalyst materials disclosed in the prior art, transition metal compounds are generally synthesized by solution hydrothermal reaction. Some materials need to undergo subsequent freeze-drying treatment, the synthesis process takes a long time, some sulfides and phosphides are needed for subsequent vulcanization and phosphating treatment, pungent odors are produced, and exhaust gas treatment is required. The material synthesis cycle is relatively long, the efficiency is low, and therefore, the method is difficult to apply to the production of large-area materials.

Finally, from the perspective of practical applications, most of the existing catalyst materials are powder materials, a binder is needed during the use of the materials, and therefore, the proton transmission efficiency is reduced. In the process of use, some catalyst materials can only be used in acidic environments, and their hydrogen evolution performance in alkaline environments is very poor, which makes their application subject to many restrictions.

The publication of International Journal of Electrochemical Science, *"*Electrochemically reduced graphene oxide/neodymium hexacyanoferrate modified electrodes for the electrochemical detection of paracetamol", by Balamurugan Devdas, Muniyandi Raj Kumar, Shen Ming Chen, and Saraswati, discloses fabricating the electrochemically reduced graphene oxide ERGO neodymium hexacyanoferrate (NdHCF) film on GCE and ITP by using cyclic volumetric(CV) surface morphological for analysing surface model morphological using scan electron microscope.

CN107245597 provides a kind of method of quick preparation silver nanoparticle purpose square graphite alkene foam nickel composite material.Mainly include following processing step: growing a layer graphene on nickel foam substrate with chemical vapour deposition technique (CVD), graphene/nickel foam substrate is prepared; silver nanoparticle side is prepared using polyol reduction method; the graphene/nickel foam substrate material is put into the reactor equipped with magneton, the silver nanoparticle side added after centrifuging dilution through acetone, it is placed in oil bath pan, rotating speed is reconciled in 260 360r/min, insulation at a certain temperature is for a period of time, take out and rinse and dry, obtain silver nanoparticle purpose square graphite alkene foam nickel composite material. The silver nanoparticle purpose square graphite alkene foam nickel composite material prepared is put into tube furnace and made annealing treatment.

WO 2017/155468 A1 provides a chemical vapor deposition process comprising heating a porous metal template at a temperature range of 500 to 2000 °C; passing a gas mixture comprising a carrier gas carrying along a vapor of an organometallic compound and at least one of a carbon precursor gas and a boron nitride precursor gas through the heated metal template, wherein the heating temperature causes the decomposition of the organometallic compound vapor into metal particles, the carbon precursor gas into graphene domains, and/or the boron nitride precursor gas into hexagonal-boron nitride domains, further wherein the graphene domains and/or the hexagonal-boron nitride domains nucleate and grow on the metal particles and the metal template to form a three-dimensional interconnected porous network of graphene and/or the hexagonal-boron nitride. There is also provided a foam-like structure produced by a process as described above. There is also provided a foam-like structure as described above for use in electrochemistry, solar cells, filler, thermal interface material, sensing or biological applications.

The Publication of Materials Science and Engineering B, "Three-Dimensional Graphene Synthesis on Nickel Foam by Chemical Vapour Deposition from Ethylene ", by Trinsoutrot Pierre *ET AL* discloses 3D multi-layer graphene networks synthesized on nickel foam from ethylene between 700 and 1000 degree C by chemical vapour deposition large nickel foam substrates that are with accurate measurement of graphene masses. The weight of graphene increases with run duration and when decreasing temperature. Graphene is also present inside the hollow branches of the foam.

Based on the technical shortcomings of current catalyst materials, it is necessary to improve this.

### SUMMARY

In view of the above problems, the present invention provides a neodymium-graphene composite material and a preparation method and an application thereof so as to solve or at least partially solve the technical problems in the prior art.

The present invention provides a preparation method of a neodymium-graphene composite material, which comprises the steps of:
step 1. growing graphene on a nickel foam surface of a substrate by using nickel foam a chemical vapor deposition method with carbon-containing gas as a carbon source to obtain a graphene nickel foam material, the process of growing the graphene on the surface of the nickel foam substrate by using the chemical vapor deposition method to obtain the graphene nickel foam material in the step 1 comprises: placing nickel foam in the tube furnace, introducing a gas mixture of hydrogen and argon, then increasing the temperature to 900-1200°C, and introducing carbon source gas to grow the graphene on the surface of the nickel foam substrate,
the time for introducing the carbon source gas is 15-25 minutes, and the flow rate of the carbon source gas is 90-110 sccm,
the graphene nickel foam material is placed in a tube furnace, meanwhile the gas mixture of hydrogen and argon is introduced, and the flow rate of the gas mixture is 90-110 sccm, and
the nickel foam is cleaned by using ethanol before the nickel foam is placed in the tube furnace; and
step 2. preparing neodymium(Nd) elements on the graphene surface of the graphene nickel foam material to obtain a neodymium-graphene composite material, the preparation method of the neodymium-graphene composite material, characterized in that the preparation of the neodymium elements on the graphene surface of the graphene nickel foam material described in the step 2 specially comprises: placing the graphene nickel foam material in a tube furnace, placing neodymium fluoride(NdF₃) powder in the tube furnace, and heating to 1200-1400 °C, so that the neodymium fluoride is volatilized and decomposed to produce neodymium-containing elements, and the neodymium-containing elements are deposited on a surface of the graphene, and
the preparation method of the neodymium-graphene composite material, characterized in that the preparation of the neodymium elements on the graphene surface of the graphene nickel foam material described in the step 2 specially comprises: soaking the graphene nickel foam material in a neodymium nitrate or neodymium sulfate solution, taking out the graphene nickel foam material, drying the graphene nickel foam material, and then conducting heat treatment on the graphene nickel foam material in inert gas.

Further, the preparation method of the neodymium-graphene composite material, characterized in that the carbon source in the step 1 comprises one of ethylene, methane and acetylene.

Further, a neodymium-graphene composite material, characterized by being prepared by the preparation method.

The neodymium-graphene composite material can be applied to a device for producing hydrogen by water electrolysis as an electrode material, or be applied to a fuel cell or a metal-air battery as a cathode material.

Compared with the prior art, the preparation method of the neodymium-graphene composite material has the following beneficial effects:
(1). according to the preparation method of the neodymium-graphene composite material, the nickel foam is used as the substrate. The nickel foam is an electrically conductive 3D porous material with low price and good performance, can act as a skeleton when being used as the substrate, can avoid graphene stacking and allow graphene to be fully spread out; at the same time, neodymium in neodymium fluoride is a rare earth element, and due to the unique properties of 4f electrons in the neodymium, the electrochemical catalytic efficiency of hydrogen evolution reaction, oxygen evolution reaction, oxygen reduction reaction and the like can be significantly improved by combining the neodymium with an electrocatalyst; according to the preparation method of the neodymium-graphene composite material, the neodymium-graphene composite material is synthesized in one step by a chemical vapor deposition method, the synthesis process is simple, the cycle is relatively short, and the efficiency is high, and therefore, the preparation method can be applied to the production of large-area materials; according to the preparation method of the neodymium-graphene composite material, raw materials are abundant in source, cheap, easy to obtain, and pollution-free to environments; according to the preparation method of the neodymium-graphene composite material, by changing the heating temperature of neodymium fluoride powder in a tube furnace, the morphology of the composite material can be adjusted and controlled, and spherical and fibrous neodymium compounds are synthesized on the surface of the graphene, so that the specific surface area and electrochemical active area of the composite material can be increased, and then the hydrogen evolution performance of the composite material is improved; the composite material prepared in this application has the advantages of uniform surface morphology, large specific surface area, good electrochemical performance, low hydrogen evolution overpotential, and etc.. Combined with the advantages mentioned above, the performance of the composite material is improved, and the material has a self-supporting structure and does not need a binder during use.

### BRIEF DESCRIPTION OF DRAWINGS

In order to explain the embodiments of the present invention or the technical solutions in the prior art more clearly, the drawings that need to be used in the description of the embodiments or the prior art will be briefly introduced below. Obviously, the drawings in the following description are only some embodiments of the present invention, and other drawings can be obtained based on these drawings by those of ordinary skill in the art without creative work.
FIG. 1 is surface morphology graphs of neodymium-graphene composite materials prepared in Examples 1 and 2 of the present invention and a graphene nickel foam material prepared in Comparative Example 1;
FIG. 2 is an adsorption-desorption curve graph of the graphene nickel foam material prepared in Comparative Example 1;
FIG. 3 is a nitrogen adsorption-desorption curve graph of the neodymium-graphene composite material prepared in Example 2 of the present invention;
FIG. 4 is a nitrogen adsorption-desorption curve graph of the neodymium-graphene composite material prepared in Example 1 of the present invention; and
FIG. 5 is hydrogen evolution curve graphs of the neodymium-graphene composite materials prepared in Examples 1 and 2 of the present invention, the graphene nickel foam material prepared in Comparative Example 1, and pure nickel foam in a 1 mol/L KOH solution.

### DETAILED DESCRIPTION OF THE EMBODIMENTS

The present invention provides a preparation method of a neodymium-graphene composite material, which comprises the steps of:
step 1. growing graphene on a nickel foam surface of a substrate by using nickel foam a chemical vapor deposition method with carbon-containing gas as a carbon source to obtain a graphene nickel foam material, the process of growing the graphene on the surface of the nickel foam substrate by using the chemical vapor deposition method to obtain the graphene nickel foam material in the step 1 comprises: placing nickel foam in the tube furnace, introducing a gas mixture of hydrogen and argon, then increasing the temperature to 900-1200°C, and introducing carbon source gas to grow the graphene on the surface of the nickel foam substrate,
the time for introducing the carbon source gas is 15-25 minutes, and the flow rate of the carbon source gas is 90-110 sccm,
the graphene nickel foam material is placed in a tube furnace, meanwhile the gas mixture of hydrogen and argon is introduced, and the flow rate of the gas mixture is 90-110 sccm, and
the nickel foam is cleaned by using ethanol before the nickel foam is placed in the tube furnace;
   and
step 2. preparing neodymium(Nd) elements on the graphene surface of the graphene nickel foam material to obtain a neodymium-graphene composite material, the preparation of the neodymium elements on the graphene surface of the graphene nickel foam material described in the step 2 specially comprises: placing the graphene nickel foam material in a tube furnace, placing neodymium fluoride powder in the tube furnace, and heating to 1200-1400 °C, so that the neodymium fluoride is volatilized and decomposed to produce neodymium-containing elements, and the neodymium-containing elements are deposited on the surface of the graphene, and
the preparation of the Neodymium elements on the graphene surface of the graphene nickel foam material described in the step 2 specially comprises: soaking the graphene nickel foam material in a neodymium nitrate or neodymium sulfate solution, taking out the graphene nickel foam material, drying the graphene nickel foam material, and then conducting heat treatment on the graphene nickel foam material in inert gas; and specially, the inert gas is Ar gas, the heat treatment temperature is 1000-1200°C, and the heat treatment time is 10-15 minutes.

In some embodiments, the carbon source in the step 1 comprises one of ethylene, methane and acetylene.

The introduced gas mixture of hydrogen and argon can prevent the formation of oxides on the surface of the nickel foam and is conducive to the uniform growth of the graphene.

In some embodiments, in the process of growing the graphene on the surface of the nickel foam substrate by using the chemical vapor deposition method to obtain the graphene nickel foam material in the step 1, the flow rate of the introduced gas mixture of hydrogen and argon is 90-110 sccm, and the volume ratio of hydrogen to argon is (5-9):100.

The process of preparing a neodymium compound on the graphene surface of the graphene nickel foam material in the step 2, the graphene nickel foam material is placed in the tube furnace, meanwhile the gas mixture of hydrogen and argon is introduced, and the flow rate of the gas mixture is 90-110 sccm; and specially, the volume ratio of hydrogen to argon is (5-9): 100.

The process of growing the graphene on the surface of the nickel foam substrate by using the chemical vapor deposition method to obtain the graphene nickel foam material in the step 1, the nickel foam is soaked in an ethanol solution with a mass concentration of 5-10% for 5-10 minutes.

The preparation method of the neodymium-graphene composite material comprises the steps of:
placing the nickel foam in one temperature zone of the tube furnace, placing the neodymium fluoride (NdF₃) powder in the other temperature zone of the tube furnace, introducing the gas mixture of hydrogen and argon with the flow rate of 90~110 sccm, heating the temperature zone corresponding to the nickel foam to 900-1200 °C, heating the temperature zone corresponding to the neodymium fluoride powder to 1200-1400 °C, meanwhile conducting heat preservation for 10 minutes, and then introducing ethylene gas with the flow rate of 90-110 sccm for 10 minutes, wherein, the neodymium fluoride is volatilized and decomposed at a high temperatures above 1200 °C to produce neodymium-containing elements, and the neodymium-containing elements are deposited on the surface of the graphene with the gas, and then are cooled to a room temperature with the furnace to obtain the neodymium compound graphene foamed composite material.

It should be noted that in the embodiments of the present invention, the nickel foam only adsorbs carbon atoms, and the carbon atoms are adsorbed on the surface of the nickel foam to form the graphene; when neodymium atoms and the carbon atoms are deposited at the same time, the neodymium atoms are not adsorbed on the nickel foam, after cooling, the carbon atoms form the graphene on the surface of the nickel foam, and the neodymium atoms form spherical or fibrous compounds on the surface of the graphene; the arrangement of carbon atoms helps to grow neodymium morphologies, and at the same time, as the growth mechanisms of graphene and neodymium morphologies are different, the neodymium has no effect on the growth of the graphene.

According to the preparation method of the neodymium-graphene composite material, the nickel foam is used as the substrate, is an electrically conductive 3D porous material with low price and good performance, can act as a skeleton when being used as the substrate, can avoid graphene stacking and allow graphene to be fully spread out; and meanwhile neodymium in the neodymium fluoride is a rare earth element, and due to the unique properties of 4f electrons in the neodymium, the electrochemical catalytic efficiency of hydrogen evolution reaction (HER), oxygen evolution reaction (OER), oxygen reduction reaction (ORR) and the like can be significantly improved by combining the neodymium with an electrocatalyst. According to the preparation method of the neodymium-graphene composite material, the neodymium-graphene composite material is synthesized in one step by the chemical vapor deposition method, the synthesis process is simple, the cycle is relatively short, and the efficiency is high, and therefore, the preparation method can be applied to the production of large-area materials. According to the preparation method of the neodymium-graphene composite material, raw materials are abundant in source, cheap, easy to obtain, and pollution-free to environments. According to the preparation method of the neodymium-graphene composite material, by changing the heating temperature or heat treatment temperature of the neodymium fluoride powder in the tube furnace, the morphology of the composite material can be adjusted and controlled, and spherical and fibrous neodymium compounds are synthesized on the surface of the graphene, so that the specific surface area and electrochemical active area of the composite material can be increased, and then the hydrogen evolution performance of the composite material is improved. The composite material prepared in this application has the advantages of uniform surface morphology, large specific surface area, good electrochemical performance, low hydrogen evolution overpotential, and etc. Combined with the advantages of large specific surface area of graphene and good electrical conductivity, the performance of the composite material is improved. According to the composite material of the present invention, the nickel foam is a material with a three-dimensional network structure, the graphene loaded on the nickel foam has the structure of the nickel foam and is unlike powdered materials, the structure is not easily destroyed, meanwhile the graphene nickel foam material has very good electrical conductivity and does not need to be loaded on other conductive materials, and therefore, a binder is not needed in use of the material.

Based on the same inventive concept, the present invention also provides the neodymium-graphene composite material prepared by the above-mentioned preparation method.

Based on the same inventive concept, the present invention also provides the application of the neodymium-graphene composite material prepared above. Specifically, the neodymium-graphene composite material prepared in the present invention can be directly used as an electrode material for producing hydrogen by water electrolysis, or is applied to a fuel cell, metal-air batteries and other energy devices as a cathode material; the material can not only be used as a hydrogen evolution catalyst, but also can catalyze organic matters to produce other industrial raw materials; and specifically, an organic matter solution rich in source is used as an electrolytic solution, so that the hydrogen production performance is improved, meanwhile the oxidation reaction is used to synthesize high value-added chemical products (organic substances) such as benzaldehyde and ketone organic substances.

The preparation method of the neodymium-graphene composite material is further illustrated below with specific examples.

### Example 1

The preparation method of the neodymium-graphene composite material comprises the steps of:
A1. soaking the nickel foam in the ethanol solution with the mass concentration of 5% for 8 minutes;
A2. placing the nickel foam subjected to ethanol treatment in a first temperature zone of the tube furnace, placing the neodymium fluoride powder in a second temperature zone of the tube furnace, then introducing the gas mixture of hydrogen and argon with the flow rate of 100 sccm (the volume ratio of hydrogen to argon is 5:100), heating the first temperature zone to 1100 °C, heating the second temperature zone to 1400 °C, meanwhile conducting heat preservation for 10 minutes, introducing the ethylene gas with the flow rate of 100 sccm for 10 minutes, and naturally cooling two temperature zone to a room temperature to obtain the neodymium compound graphene foamed composite material.

It should be noted that the above-mentioned tube furnace is a conventional tube furnace, and the tube furnace has at least two temperature zones, and the temperatures required by the different temperature zones can be realized by heating the different temperature zones.

### Example 2

The preparation method of the neodymium-graphene composite material provided in the present example is the same as that of Example 1, except that the temperature of the second temperature zone in the present example is 1350 °C.

### Comparative example 1

The comparative example provides the preparation method of the graphene nickel foam material, which comprises the steps of:
A1. soaking the nickel foam in the ethanol solution with the mass concentration of 5% for 8 minutes;
A2. placing the nickel foam subjected to ethanol treatment in the tube furnace, then introducing the gas mixture of hydrogen and argon with the flow rate of 100 sccm (the volume ratio of hydrogen to argon is 5: 100), heating the tube furnace to 1100 °C, introducing the ethylene gas with the flow rate of 100 sccm for 10 minutes, and naturally cooling to a room temperature to obtain the graphene nickel foam material.

### Performance test

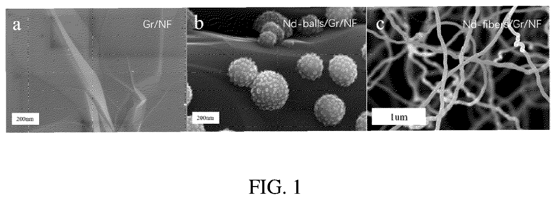

The surface morphologies of the neodymium-graphene composite material prepared in the above-mentioned Examples 1 and 2 and the graphene nickel foam material prepared in Comparative Example 1 are tested, and the results are as shown in FIG. 1 (a in FIG. 1 is the graphene nickel foam material prepared in Comparative Example 1, b is the neodymium-graphene composite material prepared in Example 2, and c is the neodymium-graphene composite material prepared in Example 1).

It can be seen from FIG. 1 that in the neodymium-graphene composite material prepared in Example 2, the neodymium elements are spherically distributed on the surface of the graphene, and in the neodymium-graphene composite material prepared in Example 1, the neodymium elements are distributed in a fibrous shape on the surface of graphene. It shows that by controlling the heating temperature of the neodymium fluoride, the neodymium elements with different morphologies can be formed and are distributed on the surface of the graphene.

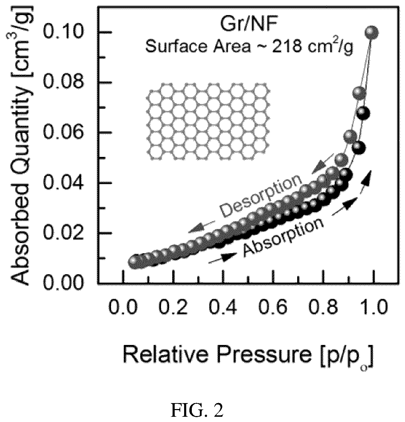

The nitrogen adsorption-desorption curves of the neodymium-graphene composite material prepared in the above-mentioned Examples 1 and 2 and the graphene nickel foam material prepared in Comparative Example 1 are tested, and the results are shown in FIG. 2 to 4. Wherein, the test method of the nitrogen adsorption-desorption curves is in accordance with a conventional test method, and comprises the steps that nitrogen is used as an adsorbent, adsorption curves are measured, then the nitrogen is removed from the sample, and desorption curves are recorded.

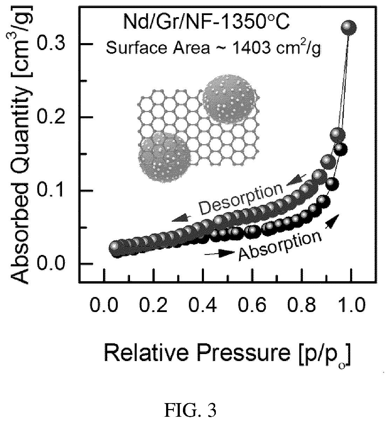

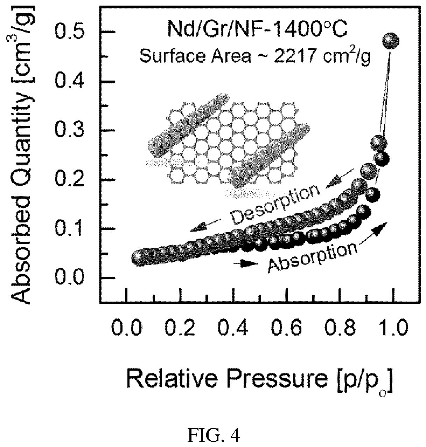

FIG. 2 is the adsorption-desorption curve graph of the graphene nickel foam material prepared in Comparative Example 1; FIG. 3 is the nitrogen adsorption-desorption curve graph of the neodymium-graphene composite material prepared in Example 2; FIG. 4 is the nitrogen adsorption-desorption curve graph of the neodymium-graphene composite material prepared in Example 1; it can be seen from FIG. 2 that the specific surface area of the graphene nickel foam material prepared in Comparative Example 1 is 218 cm²/g; it can be seen from FIG. 4 that the specific surface area of the neodymium-graphene composite material prepared in Example 1 is 2217 cm²/g; it can be seen from FIG. 3 that the specific surface area of the neodymium-graphene composite material prepared in Example 2 is 1403 cm²/g; and it can be known from the above that the material prepared in Comparative Example 1 has the largest porosity and the smallest surface area, and the neodymium-graphene composite material prepared in Example 1 has the smallest porosity and the largest specific surface area.

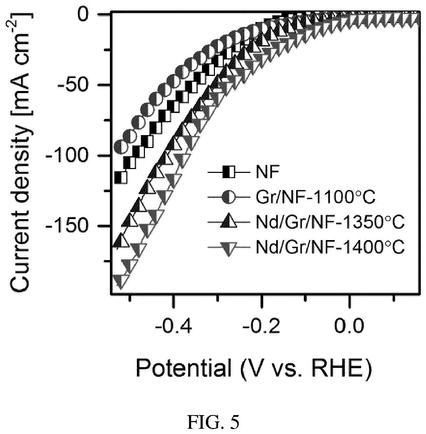

The hydrogen evolution curves of the neodymium-graphene composite materials prepared in the above-mentioned Examples 1 and 2, the graphene nickel foam material prepared in Comparative Example 1, and the pure nickel foam in a 1mol/L KOH solution are tested, and the results are shown in FIG. 5. Wherein, the specific test method of the hydrogen evolution curve comprises the steps that: a three-electrode system is adopted for operation in a 1 M KOH electrolyte on Shanghai Chenhua Electrochemical Workstation (CHI 760E), and the linear scanning voltammetry test is performed at a scanning rate of 5mV/s by respectively using the samples in Examples 1 and 2, Comparative Example 1 and the pure nickel foam as working electrodes, a graphite rod as a counter electrode, and the saturated calomel as a reference electrode to obtain the hydrogen evolution curves.

In FIG. 5, NF represents the pure nickel foam, Gr/NF-1100 °C represents the graphene nickel foam material prepared in Comparative Example 1, Nd/Gr/NF-1350 °C represents the material prepared in Example 2, and Nd/Gr/NF-1400 °C represents the material prepared in Example 1. It can be seen from FIG. 5 that the graphene growing on the nickel foam substrate is beneficial to improvement of the hydrogen evolution performance, the hydrogen evolution performance is improved after the graphene is combined with the neodymium elements, further, the neodymium-graphene composite material prepared in Example 1 requires the lowest overpotential for hydrogen evolution and still has the hydrogen evolution performance under high electric current density.

The above embodiments are only the preferred embodiments of the present invention and are not intended to limit the present invention. Any modification, equivalent replacement, improvement, etc. made within the spirit and principle of the present invention shall be included in the protection range of the present invention.

## Claims

1. A preparation method of a neodymium-graphene composite material, **characterized by** comprising the steps of:
step 1. growing graphene on a nickel foam surface of a substrate by using nickel foam a chemical vapor deposition method with carbon-containing gas as a carbon source to obtain a graphene nickel foam material, the process of growing the graphene on the surface of the nickel foam substrate by using the chemical vapor deposition method to obtain the graphene nickel foam material in the step 1 comprises: placing nickel foam in the tube furnace, introducing a gas mixture of hydrogen and argon, then increasing the temperature to 900-1200°C, and introducing carbon source gas to grow the graphene on the surface of the nickel foam substrate,
the time for introducing the carbon source gas is 15-25 minutes, and the flow rate of the carbon source gas is 90-110 sccm,
the graphene nickel foam material is placed in a tube furnace, meanwhile the gas mixture of hydrogen and argon is introduced, and the flow rate of the gas mixture is 90-110 sccm, and
the nickel foam is cleaned by using ethanol before the nickel foam is placed in the tube furnace; and
step 2. preparing neodymium elements on a graphene surface of the graphene nickel foam material to obtain a neodymium-graphene composite material, the preparation of the neodymium elements on the graphene surface of the graphene nickel foam material described in the step 2 specially comprises: placing the graphene nickel foam material in the tube furnace, placing neodymium fluoride powder in the tube furnace, and heating to 1200-1400 °C, so that the neodymium fluoride is volatilized and decomposed to produce neodymium-containing elements, and the neodymium-containing elements are deposited on a surface of the graphene, and
the preparation of the neodymium elements on the graphene surface of the graphene nickel foam material described in the step 2 specially comprises: soaking the graphene nickel foam material in a neodymium nitrate or neodymium sulfate solution, taking out the graphene nickel foam material, drying the graphene nickel foam material, and then conducting heat treatment on the graphene nickel foam in inert gas.

2. The preparation method of the neodymium-graphene composite material of claim 1, **characterized in that** the carbon source in the step 1 comprises one of ethylene, methane and acetylene.

3. A neodymium-graphene composite material, **characterized by** being prepared by the preparation method of any one of claims 1 to 2.

4. The neodymium-graphene composite material of claim 3, applied to a device for producing hydrogen by water electrolysis as an electrode material, or applied to a fuel cell or a metal-air battery as a cathode material.

## Patentansprüche

1. Herstellungsverfahren für ein Neodym-Graphen-Verbundmaterial, **dadurch gekennzeichnet, dass** es die folgenden Schritte umfasst:
Schritt 1: Aufwachsen von Graphen auf einer Oberfläche des Nickelschaumsubstrats unter Verwendung eines chemischen Dampfabscheidungsverfahrens mit kohlenstoffhaltigem Gas als Kohlenstoffquelle, um ein Graphen-Nickelschaum-Material zu erhalten, wobei das in Schritt 1 beschriebene Aufwachsen des Graphens auf einer Oberfläche des Nickelschaumsubstrats unter Verwendung eines chemischen Dampfabscheidungsverfahrens, um das Graphen-Nickelschaum-Material zu erhalten umfasst: Einbringen des Nickelschaums in den Rohrofen, Einführen einer Gasgemisch aus Wasserstoff und Argon, anschließendes Erhöhen der Temperatur auf 900-1200°C; und
Einleiten von Kohlenstoffquellengas, um das Graphen auf der Oberfläche des Nickelschaumsubstrats wachsen zu lassen,
wobei die Zeit zum Einleiten des Kohlenstoffquellengases 15-25 Minuten beträgt und die Strömungsgeschwindigkeit des Kohlenstoffquellengases 90-110 sccm beträgt,
wobei das Graphen-Nickelschaum-Material in einen Rohrofen gegeben wird, währenddessen die Gasgemisch aus Wasserstoff und Argon eingeleitet wird, wobei die Strömungsgeschwindigkeit der Gasgemisch 90-110 sccm beträgt, und
wobei der Nickelschaum mit Ethanol gereinigt wird, bevor der Nickelschaum in den Rohrofen gegeben wird; und
Schritt 2: Vorbereiten von Neodym-Elementen auf einer Graphenoberfläche des Graphen-Nickelschaum-Materials, um ein Neodym-Graphen-Verbundmaterial zu erhalten, wobei das in Schritt 2 beschriebene Vorbereiten der Neodym-Elemente auf der Graphenoberfläche des Graphen-Nickelschaum-Materials umfasst insbesondere: Einbringen des Graphen-Nickelschaum-Materials in den Rohrofen, Einbringen von Neodymfluoridpulver in den Rohrofen und Erhöhen der Temperatur auf 1200-1400 °C, so dass das Neodymfluorid verflüchtigt und zersetzt wird, um neodymhaltige Elemente zu erzeugen, wobei die neodymhaltigen Elemente auf einer Graphenoberfläche abgeschieden werden, und
wobei der Neodym-Elemente auf der Graphenoberfläche des Graphen-Nickelschaum-Materials insbesondere umfasst: Einweichen des Graphen-Nickelschaum-Materials in einer Neodymnitrat- oder Neodymsulfatlösung, Herausnehmen des Graphen-Nickelschaum-Materials, Trocknen des Graphen-Nickelschaum-Materials und anschließendes Durchführen einer Wärmebehandlung des Graphen-Nickelschaums unter Inertgas.

2. Herstellungsverfahren für ein Neodym-Graphen-Verbundmaterial nach Anspruch 1, **dadurch gekennzeichnet, dass** die Kohlenstoffquelle in Schritt 1 Ethylen, Methan oder Acetylen umfasst.

3. Neodym-Graphen-Verbundmaterial, **dadurch gekennzeichnet, dass** es nach dem Herstellungsverfahren nach einem der Ansprüche 1 bis 2 hergestellt wird.

4. Neodym-Graphen-Verbundmaterial nach Anspruch 3, das in einer Vorrichtung zur Erzeugung von Wasserstoff durch Wasserelektrolyse als Elektrodenmaterial oder in einer Brennstoffzelle oder einer Metall-Luft-Batterie als Kathodenmaterial verwendet wird.

## Revendications

1. Procédé de préparation d'une matière composite néodyme-graphène, **caractérisé en ce que** ledit procédé comprend les étapes de :
S1- formation du graphène sur une surface en mousse de nickel d'un substrat en mousse de nickel par dépôt chimique en phase vapeur avec un gaz carboné comme une source de carbone pour obtenir une matière en mousse de nickel et graphène, dans laquelle ladite formation du graphène sur une surface en mousse de nickel d'un substrat en mousse de nickel par dépôt chimique en phase vapeur comprend les sous-étapes de : placer la mousse de nickel dans le four tubulaire, introduire un mélange gazeux d'hydrogène et d'argon, faire chauffer la mixture à 900-1200°C, et introduire la gaz source de carbone pour 15~25 minutes et à un débit de 90-110 seem pour faire former le graphène à la surface du substrat en mousse de nickel,
la matière en mousse de nickel et graphène est placée dans un four tubulaire, pendant ce temps-là le mélange gazeux d'hydrogène et d'argonà est introduite à un débit de 90-110 seem, et la mousse de nickel est nettoyée en éthanol avant d'être placée dans le four tubulaire ; et
S2- préparation d'éléments de néodyme sur une surface de graphène de la matière en mousse de nickel et graphène pour obtenir une matière composite néodyme-graphène, dans laquelle ladite préparation d'éléments de néodyme sur une surface de graphène de la matière en mousse de nickel et graphène comprend les sous-étapes de : placer la matière en mousse de nickel et graphène dans le four tubulaire, placer une poudre de fluorure de néodyme dans le four tubulaire et faire chauffer la mixture à 1200-1400 °C, de sorte que le fluorure de néodyme est volatilisé et décomposé pour produire des éléments contenant du néodyme, et les éléments contenant du néodyme sont déposés sur une surface du graphène, et
dans laquelle ladite préparation d'éléments de néodyme sur une surface de graphène de la matière en mousse de nickel et graphène comprend les sous-étapes de : faire tremper la matière en mousse de nickel et graphène à une solution de nitrate de néodyme ou à une solution de sulfate de néodyme, ensuite retirer la matière en mousse de nickel et graphène, et sécher la matière en mousse de nickel et graphène, puis effectuer un traitement thermique sur la mousse de nickel et graphène dans un gaz inerte.

2. Procédé de préparation d'une matière composite néodyme-graphène selon la revendication 1, **caractérisé en ce que** la source de carbone dans S1 comprend l'un d'éthylène, de méthane et d'acétylène.

3. Matière composite néodyme-graphène, **caractérisée en ce que** elle est préparée au moyen du procédé de préparation selon l'une quelconque des revendications 1 à 2.

4. Application de la matière composite néodyme-graphène selon la revendication 3 à un dispositif de production d'hydrogène par électrolyse de l'eau comme une matière d'électrode, ou à une pile à combustible ou une batterie métal-air comme une matière de cathode.
